# EUROPEAN PATENT APPLICATION

(11) **EP 1 434 353 A1**
(43) Date of publication of application: **30.06.2004**
(21) Application number: 03257861.9
(22) Date of filing: 15.12.2003
(51) Int. Cl.: H03L 7/193

(54) **PLL synthesizer**

(30) Priority: 24.12.2002 JP 2002008156
(71) Applicant: ALPS ELECTRIC CO., LTD., Ota-ku Tokyo 145 (JP)
(72) Inventor: Yatsuda, Senichiro, Ota-ku Tokyo 145 (JP)
(74) Representative: Kensett, John Hinton

(57) **Abstract**

A PLL synthesizer includes a first frequency divider (5) for frequency-dividing an oscillation signal output from a voltage-controlled oscillator (4) to supply the divided oscillation signal to a phase comparator (3), and a register (7) for setting the division ratio of the first frequency divider (5) with external data that is input. The register (7) has a switching terminal (7a) through which a signal for switching between enablement of writing of the data and disablement of the writing of the data is input. Writing the data in accordance with the specifications of the system used can realize a PLL synthesizer capable of offering different frequencies without increasing the number of model types.
The previous data is not rewritten even when different data is erroneously input later.

## Description

The present device relates to a PLL synthesizer, having a fixed frequency, used as the source of local oscillation signals in, for example, a transmitter-receiver for mobile communication.

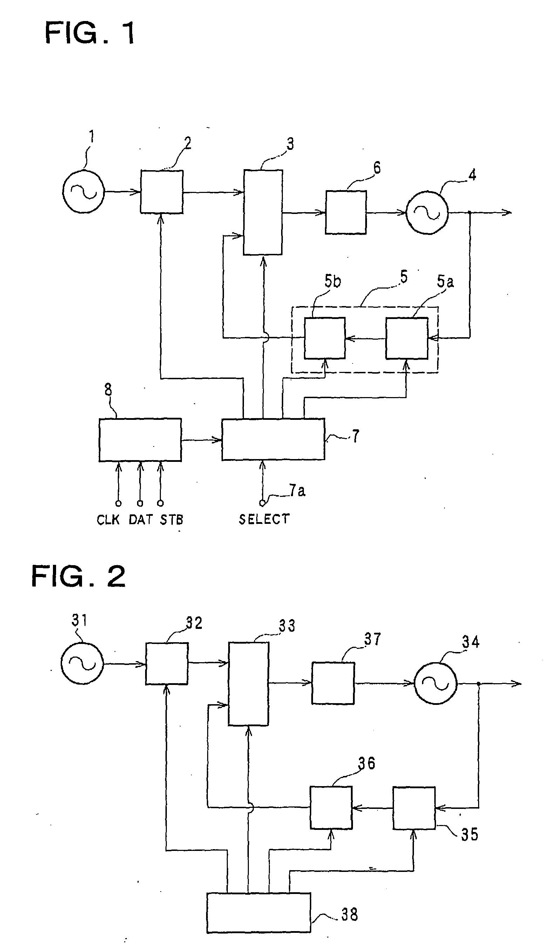

A known PLL synthesizer will now be described with reference to Fig. 2. An oscillation signal from a reference oscillator 31 is frequency-divided by a frequency divider 32 (having a division ratio R) to be supplied to one input port of a phase comparator 33 as a reference signal. An oscillation signal output from a voltage-controlled oscillator 34 is frequency-divided by a high-speed frequency divider 35 (prescaler having a division ratio P) and then is frequency-divided by a frequency divider 36 (having a division ratio N) to be supplied to the other input port of the phase comparator 33 as a comparison signal. The high-speed frequency divider 35 may be omitted.

The phase comparator 33, which includes a charge pump, generates a voltage (error voltage) corresponding to the phase difference between the reference signal and the comparison signal that are input. The generated voltage is smoothed by a low-pass filter 37.. Applying a DC voltage (control voltage), which is produced by smoothing, to the voltage-controlled oscillator 34 sets an oscillation frequency. As a result, the frequency of the reference signal coincides with the frequency of the comparison signal, the reference signal and the comparison signal being input to the phase comparator 33. In other words, the oscillation frequency of the voltage-controlled oscillator 34 is determined by the oscillation frequency of the reference oscillator 31 and the division ratios of the three frequency dividers 32, 35, and 36.

With the structure described above, the division ratios of the three frequency dividers 32, 35, and 36 are set with data stored in a register 38. The register 38 is, ordinarily, a mask-type ROM (read-only memory) in which the data is written during manufacture.

Since the oscillation frequency of the PLL synthesizer having the structure described above is set with the data written in the mask-type ROM, the PLL synthesizer cannot be used in another system having a different frequency. Hence, it is necessary to develop a new mask-type ROM for setting another oscillation frequency for such a system, thus requiring a long lead time for development and raising the cost. Furthermore, the increase in number of model types disadvantageously causes an increase in administrative costs.

Accordingly, an object of the present device is to provide a PLL synthesizer capable of arbitrarily setting an oscillation frequency that cannot be externally changed with ease.

According to an aspect of the present invention there is provided a PLL synthesizer including a first frequency divider for frequency-dividing an oscillation signal output from a voltage-controlled oscillator to supply the divided oscillation signal to a phase comparator, and a register, which is a P-ROM, for setting the division ratio of the first frequency divider with external data that is input. The register has a switching terminal through which a signal for switching between enablement of writing of the data and disablement of the writing of the data is input.

Preferably, the PLL synthesizer further includes a second frequency divider for frequency-dividing an oscillation signal output from a reference oscillator to supply the divided oscillation signal to the phase comparator. The division ratio of the second frequency divider is set by the register.

Preferably the PLL synthesizer further includes a data-latch controller for latching the input data and transferring the data to the register. The register is an EEP-ROM or a flash ROM.

An embodiment of the present invention will now be described, by way of example, with reference to the accompanying diagrammatic drawings, in which:
Fig. 1 is a circuit diagram showing the structure of a PLL synthesizer of the present device.
Fig. 2 is a circuit diagram showing the structure of a known PLL synthesizer.

A PLL synthesizer of the present device will now be described with reference to Fig. 2. An oscillation signal from a reference oscillator 1 is frequency-divided by a second frequency divider 2 (having a division ratio R) to be supplied to one input port of a phase comparator 3 as a reference signal. An oscillation signal output from a voltage-controlled oscillator 4 is frequency-divided by a first frequency divider 5 to be supplied to the other input port of the phase comparator 3 as a comparison signal. The first frequency divider 5 includes a high-speed frequency divider 5a (prescaler having a division ratio M) and an ordinary frequency divider 5b (having a division ratio N). The high-speed frequency divider 5a may be omitted.

The phase comparator 3, which includes a charge pump, generates a voltage (error voltage) corresponding to the phase difference between the reference signal and the comparison signal that are input. The generated voltage is smoothed by a low-pass filter 6. Applying a DC voltage (control voltage), which is produced by smoothing, to the voltage-controlled oscillator 4 sets an oscillation frequency. As a result, the frequency of the reference signal coincides with the frequency of the comparison signal, the reference signal and the comparison signal being input to the phase comparator 3. In other words, the oscillation frequency of the voltage-controlled oscillator 4 is determined by the oscillation frequency of the reference oscillator 1 and the division ratios of the three frequency dividers 2, 5a, and 5b.

With the structure described above, the division ratios of the three frequency dividers 2, 5a, and 5b are set with data stored in a register 7. The register 7 is a P-ROM (programmable read-only memory), in which data can be externally written, and is preferably an EEP-ROM or a flash ROM, in which electrical signals can be written. The register 7 has a function that disables rewriting after data has been written. Hence, the register 7 has a selection terminal 7a through which a signal for enabling or disabling rewriting is input.

A data-latch controller 8 is provided for writing external data. Data (DAT) is supplied to the data-latch controller 8, along with a clock (CLK) and a strobe pulse (STB). The data is temporarily stored. For example, a high voltage is applied to the selection terminal 7a of the register 7 for enabling writing. In this state, the stored data is transferred to the register 7 with the strobe pulse supplied to the data-latch controller 8 to be written in the register 7. When the selection terminal 7a is set to a low voltage (zero volts) after the data has been written, the subsequent writing is disabled. Accordingly, the data written in the register 7 is not rewritten, even when data is erroneously input.

The register 7 that is the EEP-ROM or the flash ROM enables writing of electrical signals, and furthermore, the written data is not erased even when the power is turned off. Hence, writing the data in accordance with the specifications of the system used can offer a PLL synthesizer capable of offering different frequencies without increasing the number of model types.

As described above, the PLL synthesizer of the present device includes a first frequency divider for frequency-dividing an oscillation signal output from a voltage-controlled oscillator to supply the divided oscillation signal to a phase comparator, and a register, which is a P-ROM, for setting the division ratio of the first frequency divider with external data that is input. The register has a switching terminal through which a signal for switching between enablement of writing of the data and disablement of the writing of the data is input. With this structure, writing the data in accordance with the specifications of the system used can realize a PLL synthesizer capable of offering different frequencies without increasing the number of model types. The previous data is not rewritten even when different data is erroneously input later. The written data is not erased even when the power is turned off.

The PLL synthesizer further includes a second frequency divider for frequency-dividing an oscillation signal output from a reference oscillator to supply the divided oscillation signal to the phase comparator. The division ratio of the second frequency divider is set by the register. With this structure, the frequency of the reference signal supplied to the phase comparator can also be set, so that the oscillation frequency of the voltage-controlled oscillator can be set in detail.

The PLL synthesizer further includes a data-latch controller for latching the input data and transferring the data to the register. The register is an EEP-ROM or a flash ROM. With this structure, electrical signals can be written.

## Claims

1. A PLL synthesizer comprising a first frequency divider for frequency-dividing an oscillation signal output from a voltage-controlled oscillator to supply the divided oscillation signal to a phase comparator, and a register, which is a P-ROM, for setting a division ratio of the first frequency divider with external data that is input, wherein the register has a switching terminal through which a signal for switching between enablement of writing of the data and disablement of the writing of the data is input.

2. A PLL synthesizer according to Claim 1, further comprising a second frequency divider for frequency-dividing an oscillation signal output from a reference oscillator to supply the divided oscillation signal to the phase comparator, wherein a division ratio of the second frequency divider is set by the register.

3. A PLL synthesizer according to Claim 1 or 2, further comprising a data-latch controller for latching the input data and transferring the data to the register, wherein the register is an EEP-ROM or a flash ROM.
